# EUROPEAN PATENT APPLICATION

(11) **EP 4 718 309 A1**
(43) Date of publication of application: **01.04.2026**
(21) Application number: 25197114.9
(22) Date of filing: 20.08.2025
(51) Int. Cl.: G06F 30/13, G06F 30/27, G06N 3/08

(54) **FACTORY FLOOR MODELING**

(30) Priority: 27.09.2024 US 202418899410
(71) Applicant: INTEL Corporation, Santa Clara, CA 95054 (US)
(72) Inventor: SHEOREY, Sameer, Sunnyvale, 94087 (US); PAULITSCH, Michael, 85521 Ottobrunn (DE)
(74) Representative: HGF

(57) **Abstract**

System and techniques for facility floor modeling are described herein. A scan set that includes depth data and correlated image data from various positions on a facility floor is obtained. This data includes representations of equipment in the factory. A trained model is invoked, receiving the scan set as input and producing, as output, a computer model of the equipment along with associated information. The computer model of the equipment is integrated into a larger computer model of the factory and the information regarding the equipment is stored in a data structure that corresponds to the equipment's representation within the computer model of the factory.

## Description

### BACKGROUND

Computer-aided design (CAD) is a technology used for creating, modifying, and optimizing designs within a digital framework. CAD software enables designers, engineers, or architects to produce detailed geometric representations of objects, parts, or systems in both two dimensions (2D) and three dimensions (3D). The process typically involves defining parameters such as dimensions, materials, or tolerances, which may then be iteratively adjusted. CAD systems offer capabilities for drafting, surface modeling, solid modeling, or parametric design. Many CAD tools also integrate simulation and analysis features, enabling users to evaluate structural, thermal, or fluid dynamics performance before actual production. CAD outputs are often used to generate technical drawings, visual renderings, or computer numerical control (CNC) code for manufacturing.

Building Information Modeling (BIM) is a digital process used to create and manage data related to the design, construction, or operation of buildings. A BIM database stores detailed information about the physical or functional characteristics of a building, such as geometry, spatial relationships, materials, or performance data. The BIM database enables for the integration of multiple disciplines, such as architecture, engineering, or construction, into a single coordinated model. BIM databases enable collaboration by providing a centralized platform for sharing and updating project data in real time. The BIM database may also support lifecycle management, including cost estimation, scheduling, or maintenance operations, facilitating more efficient decision-making and project execution.

Artificial intelligence (AI) is a branch of computer science focused on developing systems that may perform tasks typically involving human intelligence. These tasks may include recognition, decision-making, language processing, or problem-solving. AI systems use algorithms to analyze data, recognize patterns, or make decisions based on pre-defined rules or learned behavior. Transformer models are a class of neural network architectures used in AI, particularly for tasks involving sequential data like language. Transformers use mechanisms such as self-attention to process input data in parallel, improving the efficiency and scalability of tasks like language translation, text generation, or question answering.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 is a block diagram of an example of an environment including a system for facility floor modeling, according to an embodiment.
FIG. 2 illustrates component interactions during training, according to an embodiment.
FIG. 3 illustrates components interactions during inference, according to an embodiment.
FIG. 4 illustrates a flow diagram of an example of a method for facility floor modeling, according to an embodiment.
FIG. 5 is a block diagram illustrating an example of a machine upon which one or more embodiments may be implemented.

### DETAILED DESCRIPTION

As noted above, a BIM database for a facility (e.g., factory, warehouse, building, etc.) is a digital representation of the physical or functional characteristics of the systems that make up the facility. The BIM database typically involves inter-linked databases with information about different building systems, such as structural, mechanical, electrical, heating ventilation air-conditioning (HVAC), etc. Examples of BIM database information may include the size and location of HVAC ducts, the location and description of pumps, motors, fans, locations and description of water pipes and electrical cabling, etc. BIM database models may also contain, or be paired with, CAD models-the detailed geometric design of the different elements present in the structure. CAD models may be simple schematics-such as bounding boxes-or fully detailed representations of specific machinery or structures. 3D CAD models typically use boundary representation (BRep) to represent geometry. A BRep is a tree with the entire object at the root, the faces of the object at the first level, the edges of each face at the second level, and the vertices of each edge as leaves. The nodes hold metadata such as shape parameters (e.g. Non-Uniform Rational B-Splines (NURBS) parameters) for the face surfaces and edge curves.

BIM and CAD models are very useful for a variety of tasks, such as planning for maintenance, repairs, or upgrades. In this context, these models may be used to avoid or reduce the need for contractor on-site visits, or to improve coordination between different trades (e.g. between electrical and HVAC technicians) leading to significant time and cost savings. Another example use of these models includes faster or cheaper design and construction of future factories. In this context, detailed models of existing factories may be used as templates for the detailed design and construction of new factories, as well as expansion of existing factories. These benefits may extend to a variety of industries producing a variety of goods or services (e.g., power generation).

To create the BIM and CAD models, a multi-step process is usually used in which people create detailed models of the structure and equipment found therein. Then, people spend significant time entering in the details of the equipment (e.g., equipment identification (ID), supply voltage, flow rate, etc.). These labor intensive processes are not only expensive and time consuming, but also prone to fall out of date.

Capturing structure characteristics using visual (e.g., visual spectrum images) or depth (depth camera images or laser scans) data is a relatively quick and cost-effective way in which to get up-to-date information about a structure. This information may provide some limited benefits available to complete BIM models-such as capturing size or distance measurements or enabling remote visual inspections. However, this sensor data is not linked to existing BIM models and thus, for example, cannot be searched for specific elements and related elements cannot be retrieved. Performing useful tasks-such as a search for elements (e.g. 10 horse power(HP) motor)-and retrieving equipment or structural characteristics-such as vibration suppression requirements-is not possible from the image and depth data alone. Rather, labor intensive and expensive site visits and manual lookup of characteristics in multiple databases is typically used to supplement the sensor captured information.

Some attempts to integrate visual or depth data into structural models include software assistance to the manual implementation of BIM database entries and CAD models. This software assistance BIM production may include creating individual CAD elements that closely follow the point clouds, using images for guidance. As an example, in a point cloud of a building, the floor and walls are represented by thousands to millions of points and will be converted, by the software, into planes or rectangular boxes. Creating the BIM database in this manner is still time-consuming with one estimate of a 10,000 square-foot warehouse estimated to take 30 hours with 90% of the time being spent in this software assisted manual modeling. Some techniques, such as matching known primitives (e.g., pipes) to the scanned data may improve on the software assisted techniques, but generally still results in a labor intensive process. These processes differ from the techniques described herein in a manner similar to driver assistance (e.g., lane keeping) and full-self driving vehicles.

To address the difficulties in populating a BIM database with CAD modeling, without the time and expense of current techniques, a generative AI model (e.g. transformer architecture trained neural network model) may be used to produce BIM database entries and CAD models of facility elements from a scan set that includes depth data and image data. This technique enables the relatively easily gathered image and depth data to be converted into models and data with minimal (e.g., with no) human interaction. In an example, because the trained model produces models directly, additional difficulties in traditional BIM and CAD production pipelines are addressed. For example, a difficulty in a traditional pipeline may include the availability of some CAD models. Facility CAD models may not be available due to contractor agreement variations. That is, while in principle those CAD models exist, they are not available to the facility owner, system integrator, or facility maintenance team due to legal, organizational, technical compatibility, or similar deficiencies. Another difficulty may arise because as-built models may vary from the original design. Thus, the available CAD model (produced from the design) is not accurate to the as-built feature. Such a situation may arise for several reasons, such as a plan changed during implementation, or a construction team incorrectly implemented the feature or moved some parts (e.g. a pipe outlet is shifted slightly). Ongoing maintenance, repairs or additions to the original plan may also lead to a mismatch between the original plans and current situation. Another example difficulty may include inconsistent BIM models. Here, format, convention, detail, or availability may vary for different factories, such that different BIM models are available, but not in compatible forms.

The trained model is trained on training data constructed from an existing facility. A scan set-such as 3D point clouds (depth data) from laser scans and calibrated images (e.g., images with known camera location and orientation with-respect-to the point cloud)-of the existing facility are captured. Text from the image data may be captured (e.g., using optical character recognition (OCR)) and used to identify element tags. These tags enable CAD models or metadata for the elements to be retrieved from existing BIM databases and CAD part catalogs. The CAD models may be compared to the point cloud (e.g., through point cloud registration) to provide as-built verification. For example, a high error indicates that the facility was built differently or updated afterwards. If OCR tags are absent, or CAD models are absent, or registration fails, a 3D point cloud segmentation may be used to extract elements (e.g., surfaces, bounding boxes, etc.) from the point cloud. The element point clouds may then compared with a CAD catalog to identify as many of the elements as possible. The elements derived from the scan set form the training set.

During training, an initial model of the trained model is trained to convert the scan set to the BIM and CAD model using the training set. In an example, the trained model is a form of generative AI (e.g., transformer-based diffusion or autoregressive) model. In an example, the trained model outputs BRep geometric representations (e.g., for use in a CAD model of the facility) and metadata (e.g., for entry into the BIM database). In an example, once the trained model is deployed for a specific facility, the trained model may be fine-tuned (e.g., trained further) using feedback from a human in the loop for model refinement. This enables adapting the model to new elements (e.g. a new type of machine) as well as adapting the trained model to the specific local conditions (e.g. element tag formats or color schemes). Using the trained model for BIM database construction or updates may facilitate planning for maintenance, repairs, or upgrades, resulting in significant time and cost savings from up-to-date digital models. Additional details and examples are provided below.

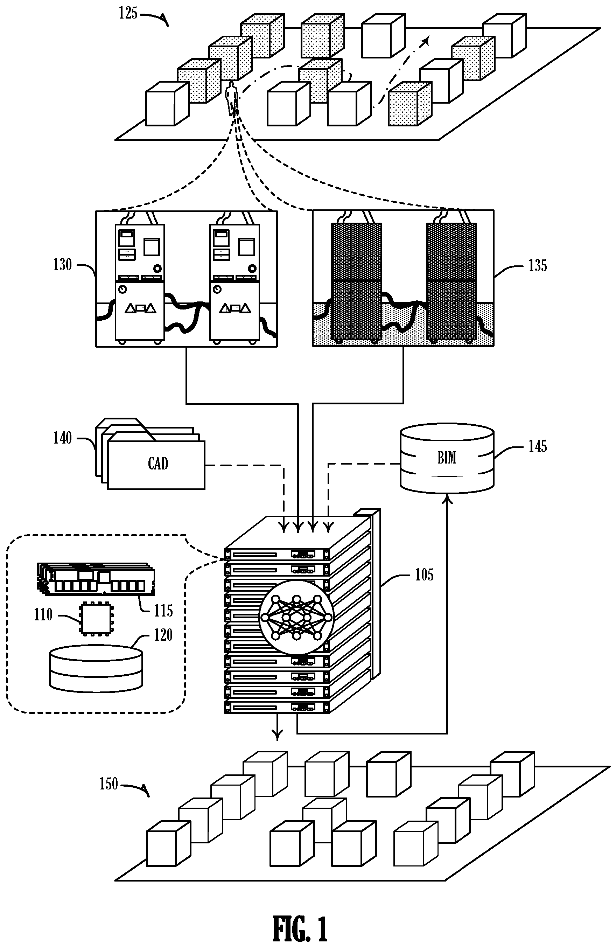

FIG. 1 is a block diagram of an example of an environment including a system 105 for facility floor modeling, according to an embodiment. The system 105 includes processing circuitry 110, storage 120 (e.g., power-stable storage such as a hard drive, solid state drive, etc.), and memory 115. The memory 115 is generally used to maintain running state information for the system 105 that is usually discarded between system power cycles or restarts. The memory 115 and the storage 120 are both forms of computer readable media. The processing circuitry 110-or software residing in the memory 115 or storage 120 executing on the processing circuitry 110-configure the system 105 to perform various operations when running.

As illustrated, a sensor (e.g., carried by a person walking through the facility floor 125) is used to capture a scan set, including image data 130 and depth data 135. The term "facility floor" is used herein to denote a place of work within a facility (e.g., factory) structure. Accordingly, this could be a room, a second story, a basement, or other area of a structure in which equipment is installed or used to facilitate the production activities of the facility.

The shaded boxes on the facility floor 125 indicate equipment that is there but not represented in the CAD models 140 or the BIM database 145. In the depth data 135, a darker shading indicates something that is closer to the sensor. In the processes that are described below, the scan set, including the image data 130 and the depth data 135, are provided as inputs into the trained model on the system 105 to produce a complete model 150 (e.g., including BIM database entries and CAD models). The CAD models 140 and the BIM database 145 may be provided as inputs to the trained model for training or, in some cases, to facilitate inference. The examples that follow are from the perspective of the processing circuitry 110 operating on the system 105.

The processing circuitry 110 is configured to obtain (e.g., receive or retrieve) the scan set. This scan set includes the depth data 135 and the image data 130 from a set of positions on the facility floor 125. The image data 130 is correlated (e.g., registered) to the depth data 135 such that they align (e.g., pixels from the image data 130 that represent a face of equipment match, when overlayed, voxels from the depth data 135 that represent the same face). The scan set is captured using one or more sensors (e.g., cameras, depth cameras, laser scanners, etc.) held by a person or equipment (e.g., a robot, drone, vehicle, etc.) moving about the facility floor 125. The scan set data may be processed to combine multiple sensors at different locations, for example, in a manner to ease downstream processing. In an example, a post-processing operation of the sensor system may include combining the camera and the lidar data at different positions of a moving person doing the scanning. This combines the image data 130 and depth data 135 to create a "colored" point cloud with absolute coordinates relative to a reference point instead of just depth data. As point cloud data resolution is often lower, the scanned image data from a camera system is also kept in processing despite being used to augment the point cloud data with color.

Some of the positions of the sensors producing the scan set, (e.g., at least one position) produce a field-of-view (FOV) includes (e.g., covers) a portion (e.g., piece) of equipment installed on the facility floor 125. The term "installed" here refers to the placement of the equipment relative to the facility floor for a product or process line based on construction of the line. Accordingly, a movable cart that is used to convey pieces from one machine to another machine is not "installed" yet a conveyer belt bolted to the floor would be "installed." Some equipment is not practically movable even if not secured to a floor or a wall. This equipment is also considered installed.

The piece of equipment may be traditional machines, such as lathes, grinders, saws, CNC machines, etc. However, other equipment that generally makes up the facility floor 125, such as electrical, fluid or gas pipes, ducting (e.g., heating, ventilation, air-conditioning (HVAC) pipes) or connections may also be considered equipment. Thus, in an example, the piece of equipment may be a machine, a pipe, a conduit, a wire, or a receptacle. In an example, the piece of equipment may include civil structure or structural items (e.g. pillars), cable trays, support structures (e.g., floors), among other things that are relevant to the construction of a CAD data of facility floor.

The processing circuitry 110 is configured to invoke (e.g., run, execute, cause to perform an inference, etc.) the trained model using the scan set as input. The output of the trained model includes a computer model of the piece of equipment and information about the piece of equipment (e.g., the complete model 150). This output does not require human intervention to complete. Rather, the CAD models and BIM database information that make up the complete model 150 may be used directly.

In an example, the processing circuitry 110 (or another system that is not illustrated) is configured to train the trained model (e.g., initial training). This process may include obtaining training data, such as obtaining a set of depth data for a second (e.g., a different) facility floor from a first sensor at different positions on the second facility floor, obtaining a set of image data for the second facility floor from a second sensor at different positions on the second facility floor, a complete Building Information Modeling (BIM) database for the second facility floor, and a complete computer model of the second facility floor. In an example, the set of depth data is aligned with the set of image data based on positions of the first sensor and the second sensor to create an aligned set of scan data. The trained model is produced by matching a training scan set to the known BIM and CAD data while minimizing error between the output of the AI model in training and the known values. Thus, in an example, the operations to train the AI model may include obtaining an initial model and iteratively adjusting the initial model based on training data. In an example, an iteration of the training includes providing an aligned set of scan data as input to produce a training output of BIM data and computer models of equipment. Error between the training output and the complete BIM database and the complete computer model of the second facility floor are measured and an internal structure of the initial model is adjusted to cause the error to be reduced. The iterations repeat with different inputs (e.g., different members of the aligned set of scan data) until the error is below a threshold.

In an example, once the trained model is produced, it may be further trained (e.g., corrected) while in operation. This training (e.g., updating, refinement, etc.) may include providing a user interface to present the output of the trained model and receiving a modification to the output of the trained model via the user interface to create a new output. Here, the user interface enables a person to review the output and make corrections. The corrections may be used in a few-shot learning technique to update the output of the trained model to more closely conform to the changes in the future. Further, the corrections provided in the user interface may be directly applied to produce the complete model 150. In this manner, a human may be "in the loop" to provide refinements during operation of the trained model.

In an example, the computer model output of the trained model of the piece of equipment is a BRep model that defines volume limits for the piece of equipment. Here, the shape (e.g., dimensions) of the piece of equipment is directly produced by the trained model. In an example, the computer model of the piece of facility equipment is one of a set of available computer models corresponding to pieces of equipment observable on the facility floor. In an example, the output of the trained model specifies a key for the computer model of the piece of equipment. This key corresponds to a pre-constructed version of the computer model for the piece of equipment. In these last few examples, the output of the trained model is used to lookup a pre-defined CAD model. While the first example in this paragraph provides the ability to determine as-built characteristics of the piece of equipment, these last examples may provide additional details of the piece of equipment that are not immediately observable in the scan set. In an example, combining these examples may enable modifying the characteristics of known CAD models with the observed characteristics.

In an example, the information about the piece of equipment includes read data obtained from image data via optical character recognition performed by the trained model. In an example, the read data includes an equipment identifier (ID), an equipment make, or an equipment model. These examples illustrate the ability to capture information that is visually available on the piece of equipment, such as the equipment ID, physical properties such as pipe pressure, a warning, out-of-order sign, etc. This information may be useful when planning changes to the facility floor 125, when planning maintenance, or in enabling a characteristic lookup in the BIM database 145 using the human readable equipment ID on the piece of equipment.

In an example, the information about the piece of equipment includes an operating parameter based on a connection to another piece of equipment. In an example, the connection is present in the scan set. In an example, the operating parameter is one of a voltage, a current, a liquid, a gas, a pressure, or a flow rate. These examples illustrate the ability to infer equipment characteristics by virtue of connection. For example, if a known electrical is 120 volts, and the piece of equipment is connected to the electrical box via a conduit, then the operating voltage of the piece of equipment may be assumed to be 120 volts. Similar assumptions may be made with respect to water or gas connections, or in connections between pieces of equipment.

Once the trained model produces the BIM database information and CAD model as output for the piece of equipment, this information is added to the CAD models 140 and the BIM database 145 to complete the process. Thus, the processing circuitry 110 is configured to place the computer model of the piece of equipment into a computer model of the facility floor (e.g., in the complete model 150). The processing circuitry 110 is also configured to write the information about the piece of equipment into a data structure (e.g., field, entry, row, etc.) that corresponds to the computer model of the piece of equipment into the computer model of the facility floor (e.g., the complete model 150). In this example, the information about the equipment may be written into metadata of an object in the complete model 150. However, in an example, the data structure is part of the BIM database 145. In this manner, the complete model 150 includes both the 3D modeling of the facility floor 125 and information about the modeled equipment in a format that is easy to search and use.

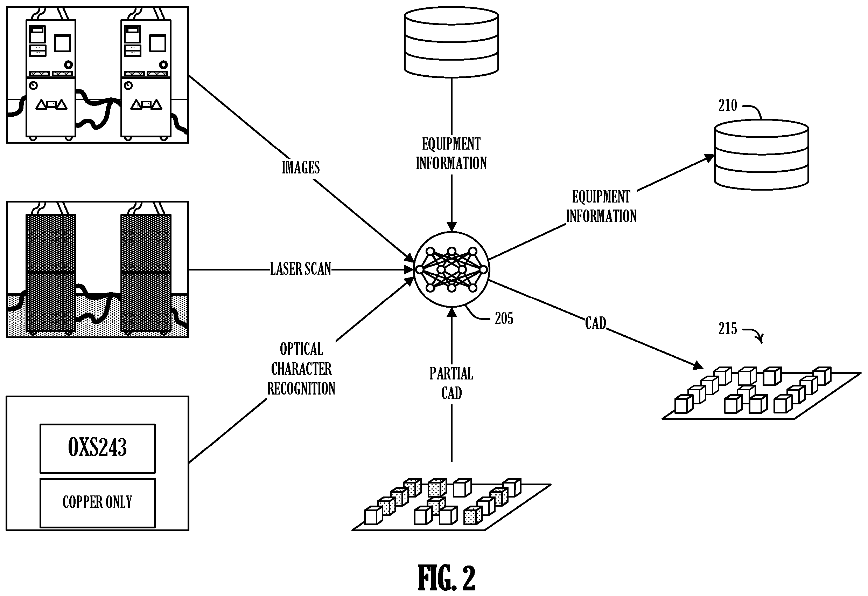

FIG. 2 illustrates component interactions during training, according to an embodiment. During training, existing equipment labels are used to retrieve data from the equipment databases, which contain shapes or equivalent CAD information,. This data is then used to position and fit objects within 3D space, based on images and point clouds, while also linking this information to BIM data. The output of the model 205 is the CAD data 215 and equipment information 210. Thus, the existing equipment information and the outputted equipment information 210 may be compared for errors as well as the existing CAD data and the outputted CAD data 215. Minimizing these errors by changing parameters of the AI model 205 results in the trained model described herein.

In an example, 3D point clouds (e.g., captured through laser scans) and images (e.g., panoramic images) of the facility are provided as input to the model 205. These images are calibrated such that the camera's location and orientation in relation to the point cloud are known. In an example, optical character recognition is applied to the images to extract and identify element tags. In an example, this process may include scene text detection and recognition-which is more complex than standard OCR-because the text may appear in varying locations, orientations, sizes, or on complex surfaces such as cylindrical pipes. In an example, a pre-trained scene text detection model may be used and fine-tuned on labeled facility images. In an example, the recognition models are adjusted to match the specific tag format in use at the facility.

In an example, CAD models (e.g., partial CAD) and BIM data (equipment information) from existing databases or CAD part catalogs are provided as input to the model 205 and compared with the point cloud data using point cloud registration, which enables verification of the as-built structure. In an example, the CAD models are converted into standard triangle meshes, and points are sampled from the surface of these meshes. The point cloud obtained from the laser scans then may be registered with the CAD-derived point cloud. The coordinates of the identified tags may be used to initialize the registration process. Any large errors (e.g., beyond a predefined threshold) may suggest that the facility may have been constructed differently or updated after the original plans were created.

In an example, If OCR tags or CAD models are missing, or if the registration process fails, a 3D point cloud semantic segmentation technique may be used to extract elements directly from the point cloud. For example, a pre-trained 3D semantic segmentation model may be fine-tuned on successfully registered facility data. The segmented point clouds then may be compared with the CAD and BIM catalogs to identify as many elements as possible. A successful registration process provides as-built verification, while the segmentation and catalog matching processes may update the CAD and BIM models. All verified elements may form the training set for the AI model. The model is then trained using a technique appropriate to the model (e.g., a pairwise input-output for a transformer) to produce the trained version of the model 205. The model 205 may be considered a generative diffusion model at this point.

Training may involve producing the generative diffusion model using existing CAD and BIM models, either generated or sourced from other databases. During training, the generative diffusion model (e.g., "BIMGen") is produced and uses point clouds and panoramic images of the facility as input to generate CAD models 215 and BIM metadata (e.g., the equipment information 210) as output, even in cases where equipment IDs or BIM data may be missing. The inputs for this model 205 may include 3D point clouds, images, and tag text, which are linked to CAD models and BIM metadata during training. In cases where an incomplete database of CAD or BIM data is available, it may also be incorporated into the model's training process.

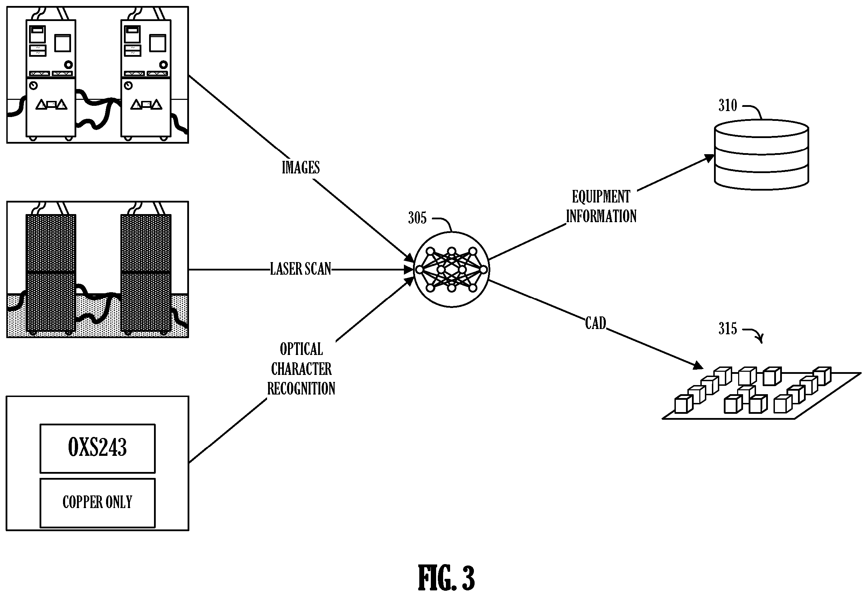

FIG. 3 illustrates components interactions during inference, according to an embodiment. Here, the model 305 is trained and accepts only images (e.g., including optical character recognition text from the images) and depth data (e.g., a laser scan) as input to produce the equipment information 310 (e.g., Bim data or BIM metadata) and computer model 315 (e.g., a CAD model) as output. Thus, inference uses the model 305 to generate accurate representations of factory equipment in 3D space based on lidar scans and images. The model 305 may produce CAD plans of equipment, along with the corresponding BIM metadata , which is then linked to the point clouds and images, for example, for further analysis or use. This enables search or planning functions using the generated CAD or BIM data.

In an example, to verify the accuracy of the generated models, a human-in-the-loop system may be employed. Here, a user may review the generated CAD models and BIM metadata, with the ability to make corrections. Errors are typically observed in areas where the available visual or geometric information is insufficient to distinguish equipment properties. For instance, distinguishing between painted plastic and metal pipes may pose challenges, and reliance on a probability distribution from the training data-a simplified example being information such as 70% of painted pipes are metal and the remaining 30% are plastic in the factories in the training dataset-may lead to errors when the data distribution changes over time. Once verified and corrected by the user, the data may be used to fine-tune the model 305 for improved performance.

In an example, the model 305 generates CAD models from noise using a transformer-based denoising diffusion system. Here, a geometry element (e.g., face, edge, or vertex) is represented in a latent space, while connectivity between elements is modeled through duplicated nodes. For example, an edge between two faces occurs twice, as a child of each face. In the generation process, faces may be conditioned solely on global position, edges on latent face codes, and vertices on latent edge codes. A shared transformer backbone may be employed for this production with multiple heads for these different tasks.

In an example, the model 305 extends the architecture above by conditioning the generation on input data, including point clouds, images, and text. In addition to producing CAD models, the model 305 thus extended outputs structured BIM metadata, for example, represented as key-value pairs encoded as text. In an example, the input data is encoded into a latent space that is shared with the BRep encoder. The model 305 may be trained by fine-tuning pre-trained text, image, point cloud, and BRep encoders, along with BIM metadata text, based on the training data.

In an example, the model 305 architecture may use input conditioning in a manner similar to text conditioning in stable diffusion models. Here, attention layers may be incorporated within the model 305 to condition the denoising process on the input data. A separate head may be added to generate BIM metadata as key-value pairs.

With these features of the architecture of the model 305, training may include encoding the multiple input data types-e.g., text, images, point clouds, or BReps-into a common latent space. In an example, a contrastive loss function- similar to the one used in Contrastive Language-Image Pretraining (CLIP)-may be employed to ensure similarity between the embeddings. In an example, the encoders are first pre-trained on synthetic data, such as CAD models, sampled point clouds, rendered images, or generated text descriptions of those images. After pre-training, the model 305 is fine-tuned using factory-specific data to further improve its accuracy.

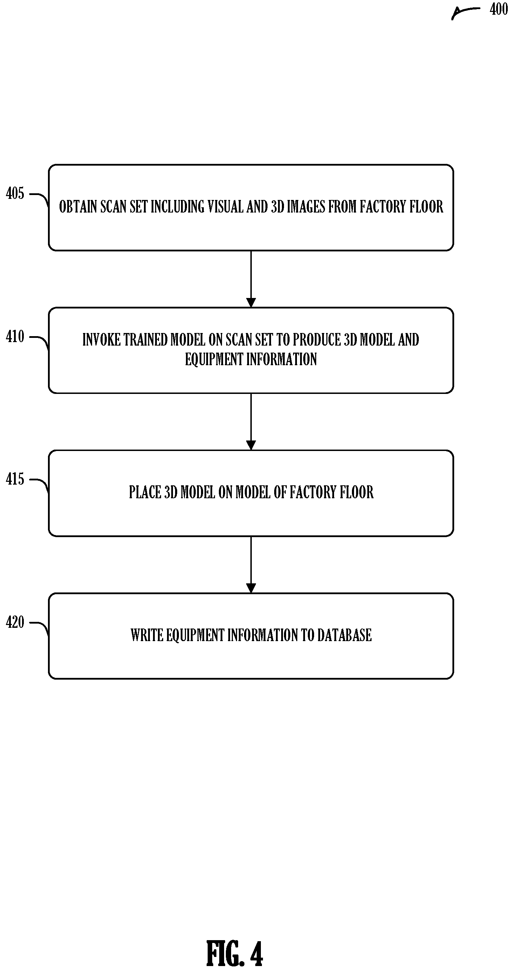

FIG. 4 illustrates a flow diagram of an example of a method 400 for facility floor modeling, according to an embodiment. The operations of the method 400 are performed by computational hardware, such as that described above or below (e.g., processing circuitry).

At operation 405, a scan set is obtained. This scan set includes depth data and correlated image data collected from a set of positions on a facility floor. From a position in the set of positions, a field-of-view (FOV) represented in the scan set (e.g., image data and depth data) includes (e.g., covers) a piece of equipment installed on the facility floor. In an example, the piece of equipment is a machine, a pipe, a conduit, a wire, or a receptacle.

At operation 410, a trained model is invoked using the scan set as input. The output of the trained model includes a computer model of the piece of equipment and information about the piece of equipment. In an example, the trained model is a generative AI model. In an example, the generative AI model is a transformer model. In an example, the generative AI model is a generative adversarial network (GAN) model. In an example, the generative AI model is a diffusion model. In an example, the generative AI model is a variational autoencoder model. In an example, the generative AI model is a neural radiance fields (NeRFs) model.

In an example, the computer model of the piece of equipment is a Boundary Representation (BRep) model that defines volume limits for the piece of equipment. In an example, the computer model of the piece of computer equipment is one of a set of available computer models corresponding to pieces of equipment observable on the facility floor. In an example, the output of the trained model specifies a key for the computer model of the piece of equipment. This key corresponds to a pre-constructed version of the computer model for the piece of equipment.

In an example, the information about the piece of equipment includes read data obtained from image data via optical character recognition performed by the trained model. In an example, the read data includes an equipment identifier (ID), an equipment make, or an equipment model.

In an example, the information about the piece of equipment includes an operating parameter based on a connection to another piece of equipment. In an example, the connection is present in the scan set. In an example, the operating parameter is one of a voltage, a current, a liquid, a gas, a pressure, or a flow rate.

In an example, the method 400 includes the operation to train (e.g., modifying the current training) of the trained model. This training may include providing a user interface to present the output of the trained model and receiving a modification to the output of the trained model via the user interface to create a new output. In an example, the trained model is modified to conform to the new output when invoked on the input.

At operation 415, the computer model of the piece of equipment is placed into a computer model of the facility floor.

At operation 420, the information about the piece of equipment is written into a data structure that corresponds to the computer model of the piece of equipment as placed into the computer model of the facility floor. In an example, the data structure is part of a Building Information Modeling (BIM) database. In an example, input to the trained model (e.g., at operation 410) includes the BIM. In an example, the version of the BIM provided as input to the trained model is partially complete.

In an example, the operations of the method 400 may include training the trained model (e.g., initial training). These operations may include obtaining training data. The training data including obtaining a set of depth data for a second facility floor from a first sensor at different positions on the second facility floor, a set of image data for the second facility floor from a second sensor at different positions on the second facility floor, a complete Building Information Modeling (BIM) database for the second facility floor, and a complete computer model of the second facility floor. In an example, the set of depth data is aligned with the set of image data based on positions of the first sensor and the second sensor to create an aligned set of scan data.

The operations to train the trained model may include obtaining an initial model and iteratively adjusting the initial model based on the training data. In an example, an iteration of the training includes providing the aligned set of scan data as input to produce a training output of BIM data and computer models of equipment. Error between the training output and the complete BIM database and the complete computer model of the second facility floor are measured and an internal structure of the initial model is adjusted to cause the error to be reduced. The iterations repeat with different inputs (e.g., different members of the aligned set of scan data) until the error is below a threshold.

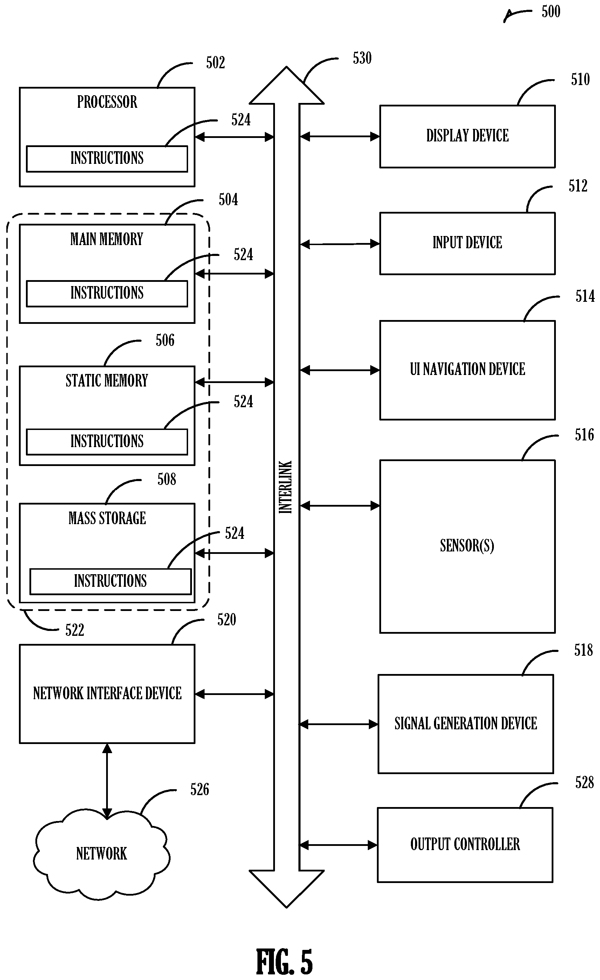

FIG. 5 illustrates a block diagram of an example machine 500 upon which any one or more of the techniques (e.g., methodologies) discussed herein may perform. Examples, as described herein, may include, or may operate by, logic or a number of components, or mechanisms in the machine 500. Circuitry (e.g., processing circuitry) is a collection of circuits implemented in tangible entities of the machine 500 that include hardware (e.g., simple circuits, gates, logic, etc.). Circuitry membership may be flexible over time. Circuitries include members that may, alone or in combination, perform specified operations when operating. In an example, hardware of the circuitry may be immutably designed to carry out a specific operation (e.g., hardwired). In an example, the hardware of the circuitry may include variably connected physical components (e.g., execution units, transistors, simple circuits, etc.) including a machine readable medium physically modified (e.g., magnetically, electrically, moveable placement of invariant massed particles, etc.) to encode instructions of the specific operation. In connecting the physical components, the underlying electrical properties of a hardware constituent are changed, for example, from an insulator to a conductor or vice versa. The instructions enable embedded hardware (e.g., the execution units or a loading mechanism) to create members of the circuitry in hardware via the variable connections to carry out portions of the specific operation when in operation. Accordingly, in an example, the machine readable medium elements are part of the circuitry or are communicatively coupled to the other components of the circuitry when the device is operating. In an example, any of the physical components may be used in more than one member of more than one circuitry. For example, under operation, execution units may be used in a first circuit of a first circuitry at one point in time and reused by a second circuit in the first circuitry, or by a third circuit in a second circuitry at a different time. Additional examples of these components with respect to the machine 500 follow.

In alternative embodiments, the machine 500 may operate as a standalone device or may be connected (e.g., networked) to other machines. In a networked deployment, the machine 500 may operate in the capacity of a server machine, a client machine, or both in server-client network environments. In an example, the machine 500 may act as a peer machine in peer-to-peer (P2P) (or other distributed) network environment. The machine 500 may be a personal computer (PC), a tablet PC, a set-top box (STB), a personal digital assistant (PDA), a mobile telephone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

The machine (e.g., computer system) 500 may include a hardware processor 502 (e.g., a central processing unit (CPU), a graphics processing unit (GPU), a hardware processor core, or any combination thereof), a main memory 504, a static memory (e.g., memory or storage for firmware, microcode, a basic-input-output (BIOS), unified extensible firmware interface (UEFI), etc.) 506, and mass storage 508 (e.g., hard drives, tape drives, flash storage, or other block devices) some or all of which may communicate with each other via an interlink (e.g., bus) 530. The machine 500 may further include a display unit 510, an alphanumeric input device 512 (e.g., a keyboard), and a user interface (UI) navigation device 514 (e.g., a mouse). In an example, the display unit 510, input device 512 and UI navigation device 514 may be a touch screen display. The machine 500 may additionally include a storage device (e.g., drive unit) 508, a signal generation device 518 (e.g., a speaker), a network interface device 520, and one or more sensors 516, such as a global positioning system (GPS) sensor, compass, accelerometer, or other sensor. The machine 500 may include an output controller 528, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.).

Registers of the processor 502, the main memory 504, the static memory 506, or the mass storage 508 may be, or include, a machine readable medium 522 on which is stored one or more sets of data structures or instructions 524 (e.g., software) embodying or utilized by any one or more of the techniques or functions described herein. The instructions 524 may also reside, completely or at least partially, within any of registers of the processor 502, the main memory 504, the static memory 506, or the mass storage 508 during execution thereof by the machine 500. In an example, one or any combination of the hardware processor 502, the main memory 504, the static memory 506, or the mass storage 508 may constitute the machine readable media 522. While the machine readable medium 522 is illustrated as a single medium, the term "machine readable medium" may include a single medium or multiple media (e.g., a centralized or distributed database, and/or associated caches and servers) configured to store the one or more instructions 524.

The term "machine readable medium" may include any medium that is capable of storing, encoding, or carrying instructions for execution by the machine 500 and that cause the machine 500 to perform any one or more of the techniques of the present disclosure, or that is capable of storing, encoding or carrying data structures used by or associated with such instructions. Non-limiting machine readable medium examples may include solid-state memories, optical media, magnetic media, and signals (e.g., radio frequency signals, other photon based signals, sound signals, etc.). In an example, a non-transitory machine readable medium comprises a machine readable medium with a plurality of particles having invariant (e.g., rest) mass, and thus are compositions of matter. Accordingly, non-transitory machine-readable media are machine readable media that do not include transitory propagating signals. Specific examples of non-transitory machine readable media may include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; and CD-ROM and DVD-ROM disks.

In an example, information stored or otherwise provided on the machine readable medium 522 may be representative of the instructions 524, such as instructions 524 themselves or a format from which the instructions 524 may be derived. This format from which the instructions 524 may be derived may include source code, encoded instructions (e.g., in compressed or encrypted form), packaged instructions (e.g., split into multiple packages), or the like. The information representative of the instructions 524 in the machine readable medium 522 may be processed by processing circuitry into the instructions to implement any of the operations discussed herein. For example, deriving the instructions 524 from the information (e.g., processing by the processing circuitry) may include: compiling (e.g., from source code, object code, etc.), interpreting, loading, organizing (e.g., dynamically or statically linking), encoding, decoding, encrypting, unencrypting, packaging, unpackaging, or otherwise manipulating the information into the instructions 524.

In an example, the derivation of the instructions 524 may include assembly, compilation, or interpretation of the information (e.g., by the processing circuitry) to create the instructions 524 from some intermediate or preprocessed format provided by the machine readable medium 522. The information, when provided in multiple parts, may be combined, unpacked, and modified to create the instructions 524. For example, the information may be in multiple compressed source code packages (or object code, or binary executable code, etc.) on one or several remote servers. The source code packages may be encrypted when in transit over a network and decrypted, uncompressed, assembled (e.g., linked) if necessary, and compiled or interpreted (e.g., into a library, stand-alone executable etc.) at a local machine, and executed by the local machine.

The instructions 524 may be further transmitted or received over a communications network 526 using a transmission medium via the network interface device 520 utilizing any one of a number of transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), LoRa/LoRaWAN, or satellite communication networks, mobile telephone networks (e.g., cellular networks such as those complying with 3G, 4G LTE/LTE-A, or 5G standards), Plain Old Telephone (POTS) networks, and wireless data networks (e.g., Institute of Electrical and Electronics Engineers (IEEE) 802.11 family of standards known as Wi-Fi^{®}, IEEE 802.15.4 family of standards, peer-to-peer (P2P) networks, among others. In an example, the network interface device 520 may include one or more physical jacks (e.g., Ethernet, coaxial, or phone jacks) or one or more antennas to connect to the communications network 526. In an example, the network interface device 520 may include a plurality of antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding or carrying instructions for execution by the machine 500, and includes digital or analog communications signals or other intangible medium to facilitate communication of such software. A transmission medium is a machine readable medium.

### Additional Notes & Examples

Example 1 is an apparatus for facility floor modeling, the apparatus comprising: a memory including instructions; and processing circuitry, configured by the instructions when in operation, to obtain a scan set, the scan set including depth data and correlated image data collected from a set of positions on a facility floor, a field-of-view (FOV) represented in the scan set including a portion of equipment installed on the facility floor; invoke a trained model, input to the trained model including the scan set, output of the trained model including a computer model of the portion of equipment and information about the portion of equipment; place the computer model of the portion of equipment into a computer model of the facility floor; and write the information about the portion of equipment into a data structure that corresponds to the computer model of the portion of equipment as placed into the computer model of the facility floor.

In Example 2, the subject matter of Example 1, wherein the computer model of the portion of equipment is a Boundary Representation (BRep) model that defines volume limits for the portion of equipment.

In Example 3, the subject matter of any of Examples 1-2, wherein the data structure is part of a Building Information Modeling (BIM) database.

In Example 4, the subject matter of Example 3, wherein input to the trained model includes the BIM, the BIM being partially complete.

In Example 5, the subject matter of any of Examples 1-4, wherein the computer model of the portion of computer equipment is one of a set of available computer models corresponding to portions of equipment observable on the facility floor.

In Example 6, the subject matter of Example 5, wherein the output of the trained model specifies a key for the computer model of the portion of equipment, the key corresponding to a pre-constructed version of the computer model for the portion of equipment.

In Example 7, the subject matter of any of Examples 1-6, wherein the information about the portion of equipment includes read data obtained from image data via optical character recognition performed by the trained model.

In Example 8, the subject matter of Example 7, wherein the read data includes an equipment identifier (ID), an equipment make, or an equipment model.

In Example 9, the subject matter of any of Examples 1-8, wherein the information about the portion of equipment includes an operating parameter based on a connection to another portion of equipment, the connection present in the scan set.

In Example 10, the subject matter of Example 9, wherein the operating parameter is one of a voltage, a current, a liquid, a gas, a pressure, or a flow rate.

In Example 11, the subject matter of any of Examples 1-10, wherein the portion of equipment is a machine, a pipe, a conduit, a wire, or a receptacle.

In Example 12, the subject matter of any of Examples 1-11, wherein the processing circuitry is configured by the instructions to train the trained model including: providing a user interface to present the output of the trained model; receiving a modification to the output of the trained model via the user interface to create a new output; and modifying the trained model to conform to the new output when invoked on the input.

In Example 13, the subject matter of any of Examples 1-12, wherein the processing circuitry is configured by the instructions to create the trained model including: obtaining an initial model; obtaining a set of depth data for a second facility floor from a first sensor at different positions on the second facility floor; obtaining a set of image data for the second facility floor from a second sensor at different positions on the second facility floor; aligning the set of depth data with the set of image data based on positions of the first sensor and the second sensor to create an aligned set of scan data; obtaining a complete Building Information Modeling (BIM) database for the second facility floor; obtaining a complete computer model of the second facility floor; and iteratively adjusting the initial model by: providing the aligned set of scan data as input and producing a training output of BIM data and computer models of equipment; measuring an error between the training output and the complete BIM database and the complete computer model of the second facility floor; adjusting an internal structure of the initial model to cause the error to be reduced; and repeating with different inputs until the error is below a threshold.

In Example 14, the subject matter of any of Examples 1-13, wherein the trained model is a transformer model.

Example 15 is a method for facility floor modeling, the method comprising: obtaining a scan set, the scan set including depth data and correlated image data collected from a set of positions on a facility floor, a field-of-view (FOV) represented in the scan set including a portion of equipment installed on the facility floor; invoking a trained model, input to the trained model including the scan set, output of the trained model including a computer model of the portion of equipment and information about the portion of equipment; placing the computer model of the portion of equipment into a computer model of the facility floor; and writing the information about the portion of equipment into a data structure that corresponds to the computer model of the portion of equipment as placed into the computer model of the facility floor.

In Example 16, the subject matter of Example 15, wherein the computer model of the portion of equipment is a Boundary Representation (BRep) model that defines volume limits for the portion of equipment.

In Example 17, the subject matter of any of Examples 15-16, wherein the data structure is part of a Building Information Modeling (BIM) database.

In Example 18, the subject matter of Example 17, wherein input to the trained model includes the BIM, the BIM being partially complete.

In Example 19, the subject matter of any of Examples 15-18, wherein the computer model of the portion of computer equipment is one of a set of available computer models corresponding to portions of equipment observable on the facility floor.

In Example 20, the subject matter of Example 19, wherein the output of the trained model specifies a key for the computer model of the portion of equipment, the key corresponding to a pre-constructed version of the computer model for the portion of equipment.

In Example 21, the subject matter of any of Examples 15-20, wherein the information about the portion of equipment includes read data obtained from image data via optical character recognition performed by the trained model.

In Example 22, the subject matter of Example 21, wherein the read data includes an equipment identifier (ID), an equipment make, or an equipment model.

In Example 23, the subject matter of any of Examples 15-22, wherein the information about the portion of equipment includes an operating parameter based on a connection to another portion of equipment, the connection present in the scan set.

In Example 24, the subject matter of Example 23, wherein the operating parameter is one of a voltage, a current, a liquid, a gas, a pressure, or a flow rate.

In Example 25, the subject matter of any of Examples 15-24, wherein the portion of equipment is a machine, a pipe, a conduit, a wire, or a receptacle.

In Example 26, the subject matter of any of Examples 15-25, comprising training the trained model including: providing a user interface to present the output of the trained model; receiving a modification to the output of the trained model via the user interface to create a new output; and modifying the trained model to conform to the new output when invoked on the input.

In Example 27, the subject matter of any of Examples 15-26, comprising creating the trained model including: obtaining an initial model; obtaining a set of depth data for a second facility floor from a first sensor at different positions on the second facility floor; obtaining a set of image data for the second facility floor from a second sensor at different positions on the second facility floor; aligning the set of depth data with the set of image data based on positions of the first sensor and the second sensor to create an aligned set of scan data; obtaining a complete Building Information Modeling (BIM) database for the second facility floor; obtaining a complete computer model of the second facility floor; and iteratively adjusting the initial model by: providing the aligned set of scan data as input and producing a training output of BIM data and computer models of equipment; measuring an error between the training output and the complete BIM database and the complete computer model of the second facility floor; adjusting an internal structure of the initial model to cause the error to be reduced; and repeating with different inputs until the error is below a threshold.

In Example 28, the subject matter of any of Examples 15-27, wherein the trained model is a transformer model.

Example 29 is at least one machine readable medium including instructions for facility floor modeling, the instructions, when executed by processing circuitry, cause the processing circuitry to perform operations comprising: obtaining a scan set, the scan set including depth data and correlated image data collected from a set of positions on a facility floor, a field-of-view (FOV) represented in the scan set including a portion of equipment installed on the facility floor; invoking a trained model, input to the trained model including the scan set, output of the trained model including a computer model of the portion of equipment and information about the portion of equipment; placing the computer model of the portion of equipment into a computer model of the facility floor; and writing the information about the portion of equipment into a data structure that corresponds to the computer model of the portion of equipment as placed into the computer model of the facility floor.

In Example 30, the subject matter of Example 29, wherein the computer model of the portion of equipment is a Boundary Representation (BRep) model that defines volume limits for the portion of equipment.

In Example 31, the subject matter of any of Examples 29-30, wherein the data structure is part of a Building Information Modeling (BIM) database.

In Example 32, the subject matter of Example 31, wherein input to the trained model includes the BIM, the BIM being partially complete.

In Example 33, the subject matter of any of Examples 29-32, wherein the computer model of the portion of computer equipment is one of a set of available computer models corresponding to portions of equipment observable on the facility floor.

In Example 34, the subject matter of Example 33, wherein the output of the trained model specifies a key for the computer model of the portion of equipment, the key corresponding to a pre-constructed version of the computer model for the portion of equipment.

In Example 35, the subject matter of any of Examples 29-34, wherein the information about the portion of equipment includes read data obtained from image data via optical character recognition performed by the trained model.

In Example 36, the subject matter of Example 35, wherein the read data includes an equipment identifier (ID), an equipment make, or an equipment model.

In Example 37, the subject matter of any of Examples 29-36, wherein the information about the portion of equipment includes an operating parameter based on a connection to another portion of equipment, the connection present in the scan set.

In Example 38, the subject matter of Example 37, wherein the operating parameter is one of a voltage, a current, a liquid, a gas, a pressure, or a flow rate.

In Example 39, the subject matter of any of Examples 29-38, wherein the portion of equipment is a machine, a pipe, a conduit, a wire, or a receptacle.

In Example 40, the subject matter of any of Examples 29-39, wherein the operations comprise training the trained model including: providing a user interface to present the output of the trained model; receiving a modification to the output of the trained model via the user interface to create a new output; and modifying the trained model to conform to the new output when invoked on the input.

In Example 41, the subject matter of any of Examples 29-40, wherein the operations comprise creating the trained model including: obtaining an initial model; obtaining a set of depth data for a second facility floor from a first sensor at different positions on the second facility floor; obtaining a set of image data for the second facility floor from a second sensor at different positions on the second facility floor; aligning the set of depth data with the set of image data based on positions of the first sensor and the second sensor to create an aligned set of scan data; obtaining a complete Building Information Modeling (BIM) database for the second facility floor; obtaining a complete computer model of the second facility floor; and iteratively adjusting the initial model by: providing the aligned set of scan data as input and producing a training output of BIM data and computer models of equipment; measuring an error between the training output and the complete BIM database and the complete computer model of the second facility floor; adjusting an internal structure of the initial model to cause the error to be reduced; and repeating with different inputs until the error is below a threshold.

In Example 42, the subject matter of any of Examples 29-41, wherein the trained model is a transformer model.

Example 43 is a system for facility floor modeling, the system comprising: means for obtaining a scan set, the scan set including depth data and correlated image data collected from a set of positions on a facility floor, a field-of-view (FOV) represented in the scan set including a portion of equipment installed on the facility floor; means for invoking a trained model, input to the trained model including the scan set, output of the trained model including a computer model of the portion of equipment and information about the portion of equipment; means for placing the computer model of the portion of equipment into a computer model of the facility floor; and means for writing the information about the portion of equipment into a data structure that corresponds to the computer model of the portion of equipment as placed into the computer model of the facility floor.

In Example 44, the subject matter of Example 43, wherein the computer model of the portion of equipment is a Boundary Representation (BRep) model that defines volume limits for the portion of equipment.

In Example 45, the subject matter of any of Examples 43-44, wherein the data structure is part of a Building Information Modeling (BIM) database.

In Example 46, the subject matter of Example 45, wherein input to the trained model includes the BIM, the BIM being partially complete.

In Example 47, the subject matter of any of Examples 43-46, wherein the computer model of the portion of computer equipment is one of a set of available computer models corresponding to portions of equipment observable on the facility floor.

In Example 48, the subject matter of Example 47, wherein the output of the trained model specifies a key for the computer model of the portion of equipment, the key corresponding to a pre-constructed version of the computer model for the portion of equipment.

In Example 49, the subject matter of any of Examples 43-48, wherein the information about the portion of equipment includes read data obtained from image data via optical character recognition performed by the trained model.

In Example 50, the subject matter of Example 49, wherein the read data includes an equipment identifier (ID), an equipment make, or an equipment model.

In Example 51, the subject matter of any of Examples 43-50, wherein the information about the portion of equipment includes an operating parameter based on a connection to another portion of equipment, the connection present in the scan set.

In Example 52, the subject matter of Example 51, wherein the operating parameter is one of a voltage, a current, a liquid, a gas, a pressure, or a flow rate.

In Example 53, the subject matter of any of Examples 43-52, wherein the portion of equipment is a machine, a pipe, a conduit, a wire, or a receptacle.

In Example 54, the subject matter of any of Examples 43-53, comprising means for training the trained model including: means for providing a user interface to present the output of the trained model; means for receiving a modification to the output of the trained model via the user interface to create a new output; and means for modifying the trained model to conform to the new output when invoked on the input.

In Example 55, the subject matter of any of Examples 43-54, comprising means for creating the trained model including: means for obtaining an initial model; means for obtaining a set of depth data for a second facility floor from a first sensor at different positions on the second facility floor; means for obtaining a set of image data for the second facility floor from a second sensor at different positions on the second facility floor; means for aligning the set of depth data with the set of image data based on positions of the first sensor and the second sensor to create an aligned set of scan data; means for obtaining a complete Building Information Modeling (BIM) database for the second facility floor; means for obtaining a complete computer model of the second facility floor; and means for iteratively adjusting the initial model by: providing the aligned set of scan data as input and producing a training output of BIM data and computer models of equipment; measuring an error between the training output and the complete BIM database and the complete computer model of the second facility floor; adjusting an internal structure of the initial model to cause the error to be reduced; and repeating with different inputs until the error is below a threshold.

In Example 56, the subject matter of any of Examples 43-55, wherein the trained model is a transformer model.

Example 57 is at least one machine-readable medium including instructions that, when executed by processing circuitry, cause the processing circuitry to perform operations to implement of any of Examples 1-56.

Example 58 is an apparatus comprising means to implement of any.

Example 59 is a system to implement of any of Examples 1-56.

Example 60 is a method to implement of any of Examples 1-56.

The above detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is to allow the reader to quickly ascertain the nature of the technical disclosure and is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment. The scope of the embodiments should be determined with reference to the appended claims, along with the full scope of equivalents to which such claims are entitled.

## Claims

1. A method for factory floor modeling, the method comprising:
obtaining a scan set, the scan set including depth data and correlated image data collected from a set of positions on a factory floor, a field-of-view (FOV) represented in the scan set including a portion of equipment installed on the factory floor;
invoking a trained model, input to the trained model including the scan set, output of the trained model including a computer model of the portion of equipment and information about the portion of equipment;
placing the computer model of the portion of equipment into a computer model of the factory floor; and
writing the information about the portion of equipment into a data structure that corresponds to the computer model of the portion of equipment as placed into the computer model of the factory floor.

2. The method of claim 1, wherein the computer model of the portion of equipment is a Boundary Representation (BRep) model that defines volume limits for the portion of equipment.

3. The method of any of claims 1-2, wherein the data structure is part of a Building Information Modeling (BIM) database.

4. The method of claim 3, wherein input to the trained model includes the BIM, the BIM being partially complete.

5. The method of any of claims 1-4, wherein the computer model of the portion of computer equipment is one of a set of available computer models corresponding to portions of equipment observable on the factory floor.

6. The method of any of claims 1-5, wherein the information about the portion of equipment includes read data obtained from image data via optical character recognition performed by the trained model.

7. The method of claim 6, wherein the read data includes an equipment identifier (ID), an equipment make, or an equipment model.

8. The method of any of claims 1-7, wherein the information about the portion of equipment includes an operating parameter based on a connection to another portion of equipment, the connection present in the scan set.

9. The method of claim 8, wherein the operating parameter is one of a voltage, a current, a liquid, a gas, a pressure, or a flow rate.

10. The method of any of claims 1-9, wherein the portion of equipment is a machine, a pipe, a conduit, a wire, or a receptacle.

11. The method of any of claims 1-10, comprising training the trained model including:
providing a user interface to present the output of the trained model;
receiving a modification to the output of the trained model via the user interface to create a new output; and
modifying the trained model to conform to the new output when invoked on the input.

12. The method of any of claims 1-11, comprising creating the trained model including:
obtaining an initial model;
obtaining a set of depth data for a second factory floor from a first sensor at different positions on the second factory floor;
obtaining a set of image data for the second factory floor from a second sensor at different positions on the second factory floor;
aligning the set of depth data with the set of image data based on positions of the first sensor and the second sensor to create an aligned set of scan data;
obtaining a complete Building Information Modeling (BIM) database for the second factory floor;
obtaining a complete computer model of the second factory floor; and
iteratively adjusting the initial model by:
providing the aligned set of scan data as input and producing a training output of BIM data and computer models of equipment;
measuring an error between the training output and the complete BIM database and the complete computer model of the second factory floor;
adjusting an internal structure of the initial model to cause the error to be reduced; and
repeating with different inputs until the error is below a threshold.

13. The method of any of claims 1-12, wherein the trained model is a transformer model.

14. At least one machine readable medium including instruction that, when executed by processing circuitry, cause the processing circuitry to perform any method of claims 1-13.

15. A system comprising means to perform any method of claims 1-13.
